# EUROPEAN PATENT APPLICATION

(11) **EP 4 625 598 A1**
(43) Date of publication of application: **01.10.2025**
(21) Application number: 23893163.8
(22) Date of filing: 30.06.2023
(51) Int. Cl.: H01M 10/42, H05K 7/02, H05K 7/20, H01M 50/251

(54) **ENERGY STORAGE CABINET AND ENERGY STORAGE SYSTEM**

(30) Priority: 21.11.2022 CN 202211455668
(71) Applicant: BYD Company Limited, Shenzhen, Guangdong 518118 (CN)
(72) Inventor: QIU, Zhishuang, Shenzhen, Guangdong 518118 (CN); YIN, Xueqin, Shenzhen, Guangdong 518118 (CN); CAO, Hu, Shenzhen, Guangdong 518118 (CN); YIN, Xiaoqiang, Shenzhen, Guangdong 518118 (CN); YANG, Guibo, Shenzhen, Guangdong 518118 (CN)
(74) Representative: Mathys & Squire
(86) International application number: PCT/CN2023/104453
(87) International publication number: WO 2024/109063

(57) **Abstract**

An energy storage system, which has an energy storage cabinet. The energy storage cabinet comprises a housing, an energy storage module, and a battery management device. An accommodating space is defined in the housing, and the energy storage module is arranged in the accommodating space. The battery management device is arranged in the accommodating space, the battery management device is used for managing the energy storage module, and the battery management device comprises a supporting frame and a plurality of electrical elements. The supporting frame is arranged with an open side, and the plurality of electrical elements are mounted on the open side.

## Description

### CROSS-REFERENCE TO RELATED APPLICATIONS

The present disclosure claims priority to Chinese Patent Application No. 202211455668.6 filed on November 21, 2022, which is incorporated herein by reference in its entirety.

### FIELD

The present disclosure relates to the field of energy storage cabinet technologies, and in particular, to an energy storage cabinet and energy storage system.

### BACKGROUND

Battery management systems (referred to as BMSs) inside energy storage cabinets in the prior art usually adopt a closed box structure. Due to the closed structure, heat from the heating devices in the box is trapped inside the box, which makes it necessary to install fans or heat dissipation holes inside the box to expel the hot air from the box to the outside of the box and discharge it into the space of the energy storage cabinet, resulting in a complex structure for the battery management system and relatively high production costs.

### SUMMARY

The present disclosure provides a new technical solution for an energy storage cabinet, which can solve the problems of the complex structure of the battery management system and relatively high production costs caused by the closed box in the prior art.

The present disclosure also provides a new technical solution for an energy storage system, and the energy storage system includes an energy storage cabinet.

An energy storage cabinet provided according to the first aspect of the present disclosure includes: a housing, wherein an accommodation space is defined within the housing; an energy storage module, which is located in the accommodation space; and a battery management device, which is located in the accommodation space. The battery management device is configured to manage the energy storage module, and includes a support frame and a plurality of electrical components. The support frame has an open side, and the plurality of electrical components are mounted on the open side.

In an embodiment, the energy storage cabinet further includes: a temperature regulation device, and the temperature regulation device is located in the accommodation space, and the temperature regulation device can regulate the temperature in the accommodation space.

In an embodiment, the temperature regulation device includes an air conditioner.

In an embodiment, the housing includes: a body, and the accommodation space is defined within the body, and the body has a first opening; and a first cover, and the first cover is movably arranged on the body, and the first cover can open or close the first opening, and the temperature regulation device is arranged on the inner side of the first cover.

In an embodiment, the energy storage cabinet further includes: a wire compartment, and the wire compartment is arranged on the inner wall surface of the housing, and the wire compartment contains wire harnesses electrically connected to the electrical components.

In an embodiment, the battery management device is mounted on the outer side of the wire compartment.

In an embodiment, the housing includes two adjacent side walls, and the two side walls form a corner portion, and the battery management device is arranged close to the corner portion.

In an embodiment, the housing includes: a body, and the accommodation space is defined within the body, and the body has a second opening; and a second cover, and the second cover is movably arranged on the body, and the second cover can open or close the second opening, and the second opening corresponds to the position of the battery management device.

In an embodiment, the housing is arranged with a wire-passing hole along its thickness direction, and the wire harness is electrically connected to the battery management device through the wire-passing hole.

In an embodiment, the housing includes a top wall, a bottom wall, and side walls, the side walls are located between the top wall and the bottom wall and are configured to connect the top wall and the bottom wall, and the wire-passing hole is arranged on the top wall and/or the bottom wall.

In an embodiment, the support frame is made of an insulating material.

In an embodiment, the support frame includes: a first mounting frame that extends along the first direction, on which a part of the electrical components are arranged; and a second mounting frame that is arranged on the first mounting frame and extends along the second direction. There is an included angle between the first direction and the second direction, and another part of the electrical components are arranged on the second mounting frame.

In an embodiment, the first mounting frame and the second mounting frame are enclosed to form an L-shaped structure.

In an embodiment, the first mounting frame and the second mounting frame are respectively insulating material plates, and the thickness of the first mounting frame is greater than that of the second mounting frame.

The energy storage system provided according to the second aspect of the present disclosure includes: at least one energy storage cabinet, and the energy storage cabinet is any one of the aforementioned energy storage cabinets.

The corresponding structure in the prior art is a closed box structure, and a heat dissipation system needs to be set inside the closed box, resulting in a relatively complex structure. However, the battery management device of the present disclosure has an open-type structure. Thus, the original heat dissipation system inside the box is omitted. By directly exposing the electrical components to the ambient air in the accommodation space, a certain degree of heat dissipation effect on the electrical components can be achieved. Further, the original box structure is simplified. Not only can it still help limit the electrical components, but it can also reduce the overall weight of the battery management device and the energy storage cabinet.

The additional aspects and advantages of the present disclosure will become apparent through the following detailed descriptions of exemplary embodiments of the present disclosure with reference to the accompanying drawings.

### BRIEF DESCRIPTION OF THE DRAWINGS

The accompanying drawings, which are incorporated in and constitute a part of the specification, illustrate the embodiments of the present disclosure and, together with the description, serve to explain the principles of the present disclosure.
FIG. 1 is a structural schematic diagram of a battery management system of an energy storage cabinet in the prior art;
FIG. 2 is a schematic diagram of a battery management device of an energy storage cabinet according to an embodiment of the present disclosure;
FIG. 3 is a schematic diagram of an energy storage cabinet according to an embodiment of the present disclosure;
FIG. 4 is an enlarged view of the area A circled in FIG. 3.

Reference numerals
energy storage cabinet 100; housing 10; accommodation space 11; first opening 12; top wall 13; first side wall 141; second side wall 142; second opening 15; first cover 16; corner portion 17; wire-passing hole 18; battery management device 20; support frame 21; first mounting frame 211; first side surface 2111; second mounting frame 212; printed circuit board support frame 2121; pre-charge resistor support frame 2122; first connection terminal 221; second connection terminal 222; fuse 223; relay 224; copper busbar 225; isolating switch 226; printed circuit board assembly 227; pre-charge resistor 228; Bakelite^{®} base 23; isolating switch mounting plate 24; temperature regulation device 30; wire compartment 40.

### DETAILED DESCRIPTION

Now, various exemplary embodiments of the present disclosure will be described in detail with reference to the accompanying drawings. It should be noted that: unless otherwise specifically stated, the relative arrangements of components and steps, numerical expressions, and values set forth in these embodiments do not limit the scope of the present disclosure.

The following description of at least one exemplary embodiment is only illustrative and in no way serves as any limitation to the present disclosure and its application or use.

Technologies, methods, and devices known to those of ordinary skill in the relevant art may not be discussed in detail, but where appropriate, the technologies, methods, and devices should be regarded as part of the specification.

In all the examples shown and discussed herein, any specific value should be construed as merely exemplary and not as a limitation. Therefore, other examples of the exemplary embodiments may have different values.

It should be noted that: similar reference numerals and letters in the following drawings represent similar items. Therefore, once an item is defined in one drawing, there is no need for further discussion of it in subsequent drawings.

The present disclosure is an invention created by the inventor based on the following facts.

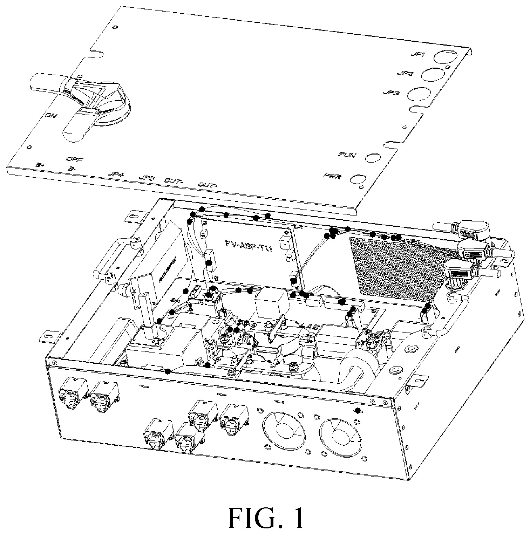

Figure 1 shows a battery management system inside an energy storage cabinet in the prior art.

As shown in Figure 1, the battery management system is a closed box. The box is made through sheet metal welding. Devices are mounted on the bottom wall of the box. A cooling fan is provided inside the box. Heat dissipation holes are set on the side wall of the box, and peripheral device interfaces are added outside the box.

The battery management system inside the above energy storage cabinet has the following defects: First, the structure is a closed box structure, which is complex. The manufacturing process of the box is usually accomplished by welding or riveting, resulting in complex manufacturing and high processing costs. Second, there are many additional peripheral device interfaces, and the components of the peripheral device interfaces are relatively expensive, increasing the additional cost. Third, a dedicated air exchange and heat dissipation system (including but not limited to fans, air ducts, heat dissipation holes, etc.) is required. The components of the entire air exchange system are complex. The additional structures (such as heat dissipation holes, etc.) make the manufacturing of components difficult, increase the additional cost, require a large amount of space, resulting in space waste, and the air exchange efficiency is low, and the heat dissipation effect is poor. Fourth, the box is made of sheet metal, and the four sides of the box are conductors. A certain electrical clearance needs to be maintained between the side wall of the box and bare high-voltage conductors such as copper busbars, increasing the difficulty of device layout and the volume of the box. Fifth, in order to insulate from the side wall of the box, insulating spacer posts and insulating films need to be added between some electrical components and the PCB board and the side wall for insulation.

Based on this, through long-term research and experiments, the inventors of the present disclosure have creatively obtained the following invention.

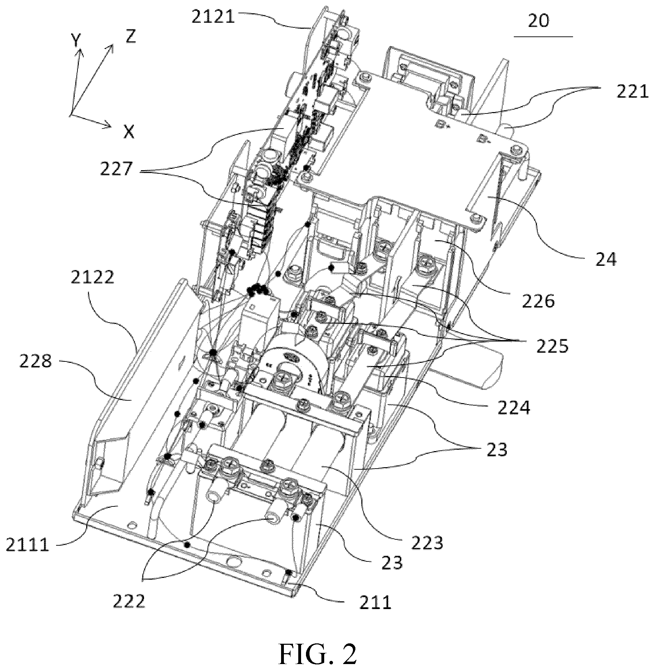

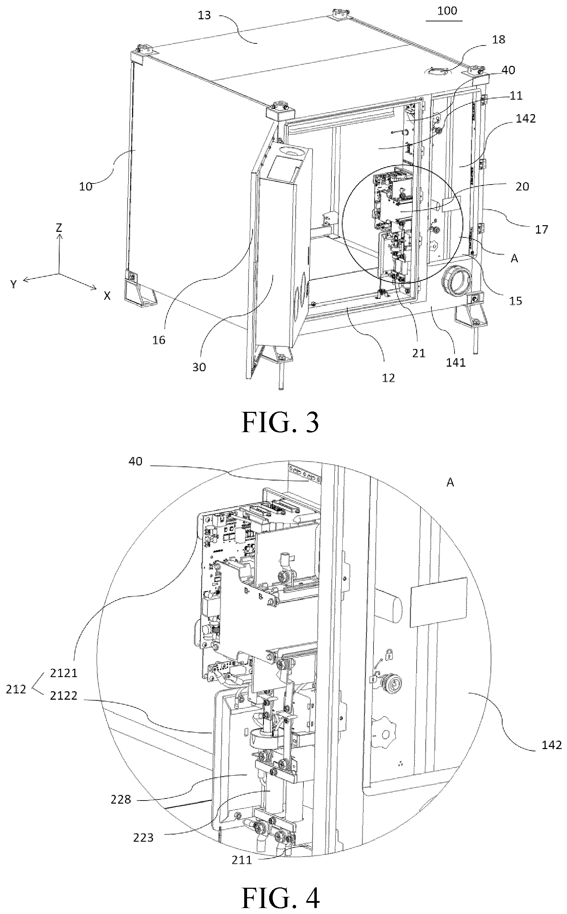

As shown in FIG. 2 to FIG. 4, the energy storage cabinet 100 according to an embodiment of the present disclosure includes a housing 10, an energy storage module, and a battery management device 20.

Specifically, an accommodation space 11 is defined inside the housing 10. The energy storage module is located in the accommodation space 11, and the battery management device 20 is also located in the accommodation space 11. The battery management device 20 is configured to manage the energy storage module. The battery management device 20 includes a support frame 21 and a plurality of electrical components. The support frame 21 has an open side, and the plurality of electrical components are mounted on the open side.

In other words, the energy storage cabinet 100 according to an embodiment of the present disclosure is mainly composed of a housing 10, an energy storage module, and a battery management device 20. An accommodation space 11 is formed inside the housing 10. Both the energy storage module and the battery management device 20 are located in the accommodation space 11. The energy storage module can be an energy storage battery module, which can be used for energy storage. The battery management device 20 can be used for battery management, and the battery management device 20 can include a high-voltage power distribution structure, etc.

It should be noted that the battery management device 20 includes a support frame 21. The support frame 21 is located in the accommodation space 11. The support frame 21 can be directly or indirectly mounted on the inner wall of the housing 10. A plurality of electrical components are arranged on the support frame 21. The support frame 21 can support and limit at least a part of the electrical components. For example, the support frame 21 supports the main circuit electrical components of the battery management device 20 and other attached interfaces. Since the support frame 21 has an open side and a plurality of electrical components are located on the open side, the electrical components on the open side can be exposed to the internal environment of the accommodation space 11, so that the electrical components can directly contact the ambient air in the accommodation space 11 and conduct heat exchange directly.

It can be seen that the battery management device 20 of the embodiment has a completely open structure, that is, an open-type structure. The electrical components are directly exposed to the environment inside the housing 10, and the electrical components can directly exchange heat with the internal environment, achieving heat dissipation of the electrical components. In addition, in terms of appearance, the prior art mainly adopts a sealed box structure, while the present disclosure adopts an open-type structure, and the overall structure is simpler.

Therefore, the corresponding structure in the prior art is a closed box structure, and a heat dissipation system needs to be set inside the closed box, resulting in a relatively complex structure. However, the battery management device 20 of the present disclosure has an open-type structure. Thus, the original heat dissipation system inside the box is omitted. By directly exposing the electrical components to the ambient air in the accommodation space 11, a certain degree of heat dissipation effect on the electrical components can be achieved. Further, the original box structure is simplified. Not only can it still help limit the electrical components, but it can also reduce the overall weight of the battery management device and the energy storage cabinet.

According to an embodiment of the present disclosure, the energy storage cabinet 100 further includes a temperature regulation device 30. The temperature regulation device 30 is located in the accommodation space 11 and can regulate the temperature in the accommodation space 11. In other words, a temperature regulation device 30 is also mounted in the accommodation space 11. The temperature regulation device 30 can control the temperature of the energy storage module and at the same time control the temperature of the open battery management device 20. It does not occupy the internal space of the battery management device 20, nor is it necessary to set two temperature-controlling structures in the accommodation space 11 for the energy storage module and the battery management device 20 respectively, without increasing additional costs.

In other words, because the present disclosure adopts an open battery management device 20, the temperature regulation device 30 inside the housing 10 can cool the internal energy storage module and at the same time cool the battery management device 20. Therefore, there is no need to additionally set an air exchange system for exchanging hot and cold air with the outside in the battery management device 20, reducing components or structures such as fans and heat dissipation holes, and also saving space.

In some specific embodiments of the present disclosure, the temperature regulation device 30 includes an air conditioner, which can improve the heat exchange effect, achieve rapid temperature control of the environment in the accommodation space 11, and can quickly control the temperature of the open battery management device 20. In an embodiment, an air duct is also set in the accommodation space 11. The air conditioner can cooperate with the air duct to control the direction of the air flow. For example, the air flow can be controlled to flow approximately from top to bottom. The gravity of the air flow can be configured to form an air-circuit cycle, which is conducive to the air flow fully flowing through the electrical components, achieving rapid heat dissipation of the electrical components and saving energy.

According to an embodiment of the present disclosure, the housing 10 includes a body and a first cover 16. The accommodation space 11 is defined inside the body. The body has a first opening 12. The first cover 16 is movably arranged on the body, and the first cover 16 can open or close the first opening 12. The temperature regulation device 30 is arranged on the inner side of the first cover 16. In other words, the temperature regulation device 30 can be mounted on the inner wall surface of the first cover 16. When the first cover 16 is opened, the temperature regulation device 30 can move together with the first cover 16, which is convenient for the maintenance and loading and unloading of the temperature regulation device 30. In addition, it can prevent the temperature regulation device 30 from always being located in the accommodation space 11, resulting in difficulty in maintaining and loading and unloading other structures inside the accommodation space 11, such as inspecting the energy storage module.

According to an embodiment of the present disclosure, the energy storage cabinet 100 further includes a wire compartment 40. The wire compartment 40 is arranged on the inner wall surface of the housing 10. A wire harness electrically connected to the electrical components is accommodated in the wire compartment 40. In other words, the wire compartment 40 is mounted on the inner wall surface of the housing 10. The wire compartment 40 has an accommodating cavity inside. A wire harness can be accommodated in the accommodating cavity, and the wire harness can be connected to the electrical components on the battery management device 20. In this embodiment, by using the wire compartment 40, it facilitates the storage and management of the wire harness and prevents the wire harness distribution from occupying too much of the accommodation space 11.

In some specific embodiments of the present disclosure, the battery management device 20 is mounted on the outer side of the wire compartment 40. For example, the first surface of the wire compartment 40 is connected to the inner wall surface of the housing 10, and the support frame 21 of the battery management device 20 is connected to the outer surface of the wire compartment 40. In this embodiment, since the wire compartment 40 has a certain thickness, it can provide stable and good support for the battery management device 20. Moreover, it can shorten the distance between the wire harness and the battery management device 20, facilitating the connection between the wire harness and the electrical components.

In some specific embodiments of the present disclosure, the housing 10 includes two adjacent side walls, and the two side walls form a corner portion 17. The battery management device 20 is arranged close to the corner portion 17. For ease of explanation, the two side walls can be defined as the first side wall 141 and the second side wall 142 respectively. In other words, the multiple side walls include the first side wall 141 and the second side wall 142 which are adjacent to each other. The first side wall 141 extends along the first direction, and the second side wall 142 extends along the second direction. Since the first direction and the second direction have an angle, the first side wall 141 and the second side wall 142 can intersect and form the corner portion 17. The battery management device 20 is arranged in the space within the accommodation space 11 that is relatively close to the corner portion 17. In this embodiment, by arranging the battery management device 20 in the space relatively close to the corner portion 17, the internal space of the housing 10 can be fully utilized, improving the space utilization efficiency.

According to an embodiment of the present disclosure, the housing 10 includes a body and a second cover. The accommodation space 11 is defined inside the body. The body has a second opening 15. The second cover is movably arranged on the body, and the second cover can open or close the second opening 15. The second opening 15 corresponds to the position of the battery management device 20. By opening the second cover, operations and maintenance of the battery management device 20 can be carried out through the second opening 15.

For example, the body includes the first side wall 141 and the second side wall 142 which are adjacent to each other. The second opening 15 is arranged on the first side wall 141. The second side wall 142 is mounted with the wire compartment 40, and the support frame 21 is mounted on the outer side of the wire compartment 40. The second cover is pivotally connected to the body, and the second cover is used to open or close the second opening 15. Since the second cover and the body can be rotatably connected, the second opening 15 can be opened or closed by the movable second cover. Because the first side wall 141 and the second side wall 142 are adjacent to each other, when the second opening 15 is opened, the electrical components on the inner side of the second side wall 142 can be observed through the second opening 15 on the first side wall 141. The distance between the electrical components and the second opening 15 is relatively small, which is convenient for operations such as mounting interfaces.

According to an embodiment of the present disclosure, the housing 10 is arranged with a wire-passing hole 18 along its thickness direction. The wire harness is electrically connected to the battery management device 20 through the wire-passing hole 18. In this embodiment, by providing the wire-passing hole 18, the connection between the battery management device 20 inside the housing 10 and the electrical devices outside the housing 10 can be realized. For example, when the number of energy storage cabinets 100 is multiple, the electrical signal transmission between two adjacent energy storage cabinets 100 can be achieved through the wire-passing hole 18 and the wire harness passing through the wire-passing hole 18.

In some specific embodiments of the present disclosure, the housing 10 includes a top wall 13, a bottom wall, and side walls. The side walls are located between the top wall 13 and the bottom wall and are configured to connect the top wall 13 and the bottom wall. The wire-passing hole 18 is arranged on the top wall 13 and/or the bottom wall, which is beneficial for stacking multiple energy storage cabinets 100 in the up-down direction. Moreover, the wire-passing hole 18 and the battery management device 20 respectively correspond to different positions on the inner walls of the housing 10, which has the advantage of a relatively simple wire routing and improves the utilization efficiency of the internal space of the housing 10.

For example, two energy storage cabinets 100 are stacked in the up-down direction. The housing 10 of each energy storage cabinet 100 respectively includes a top wall 13, a bottom wall, and multiple side walls. The multiple side walls are located between the top wall 13 and the bottom wall, and each side wall is configured to connect the top wall 13 and the bottom wall. A wire-passing hole 18 is arranged on the top wall 13 of the lower energy storage cabinet 100, and a wire-passing hole 18 is arranged on the bottom wall of the upper energy storage cabinet 100. The wire harness passes through the two wire-passing holes 18 in sequence, enabling electrical connection between the upper and lower energy storage cabinets 100.

According to an embodiment of the present disclosure, the support frame 21 is made of an insulating material. It should be noted that the closed-type box in the prior art is made by welding or riveting sheet metal plates. Since the inner walls around the box are conductors, a certain electrical clearance needs to be maintained between the inner wall of the box and bare high-voltage conductors such as the copper busbar 225, increasing the difficulty of device layout and the volume of the box. Moreover, in order to insulate from the side wall of the box, insulating materials need to be added between some devices and the side wall, such as adding insulating spacer posts and insulating films for insulation.

However, the support frame 21 in this embodiment is made of an insulating material. For example, it can not only reduce the clearance between the support frame 21 and bare high-voltage conductors such as the copper busbar 225, but also eliminate the need to additionally add an insulating layer between the support frame 21 and the wire compartment 40. The insulating support frame 21 in this embodiment can reduce the difficulty of device layout of electrical components and reduce the volume of the battery management device 20.

In an embodiment, the support frame 21 is a plate-shaped member. The first side surface 2111 of the support frame 21 is located on one side of the thickness direction of the support frame 21, and the second side surface of the support frame 21 is located on the other side of the thickness direction of the support frame 21. In other words, the support frame 21 is a plate-shaped member. One side of the thickness direction of the support frame 21 is the first side of the support frame 21, and the other side of the thickness direction of the support frame 21 is the second side of the support frame 21. In this embodiment, by defining the support frame 21 as a plate-shaped member, it is not only beneficial to the connection between the support frame 21 and the wire compartment 40, but also beneficial to the connection between the support frame 21 and the electrical components.

According to an embodiment of the present disclosure, the support frame 21 includes a first mounting frame 211 and a second mounting frame 212. The first mounting frame 211 extends along the first direction, and a part of the electrical components are arranged on the first mounting frame 211. The second mounting frame 212 is arranged on the first mounting frame 211 and extends along the second direction. There is an included angle between the first direction and the second direction, and another part of the electrical components are arranged on the second mounting frame 212.

In other words, since the first mounting frame 211 extends approximately along the first direction and the second mounting frame 212 extends approximately along the second direction, the distribution directions of the first mounting frame 211 and the second mounting frame 212 can be different in three-dimensional space. For example, the first mounting frame 211 and the second mounting frame 212 are approximately rectangular. The length directions of both the first mounting frame 211 and the second mounting frame 212 extend along the Z-axis direction. The width direction of the first mounting frame 211 extends along the X-axis direction, and the width direction of the second mounting frame 212 extends along the Y-axis direction. Therefore, by mounting a part of the electrical components on the first mounting frame 211 and another part of the electrical components on the second mounting frame 212, more installation positions for the electrical components can be distributed in three-dimensional space, expanding the distribution space of the electrical components.

For example, the first mounting frame 211 has a first side surface 2111. The second mounting frame 212 is arranged on the first side surface 2111. A part of the electrical components is arranged on the first side surface 2111 of the first mounting frame 211, and another part of the electrical components is arranged on the second mounting frame 212. In other words, both the second mounting frame 212 and a part of the electrical components are mounted on the first side surface 2111 of the first mounting frame 211, and another part of the electrical components is mounted on the second mounting frame 212. Since the positions of the second mounting frame 212 and the first mounting frame 211 are different in three-dimensional space, the electrical components can be distributed in more positions in three-dimensional space. This avoids the need to design the size of the support frame 21 in one direction to be excessively large, thus preventing the occupation of a large amount of space in one direction within the accommodation space 11.

In some specific embodiments of the present disclosure, the first mounting frame 211 and the second mounting frame 212 are enclosed to form an approximately L-shaped structure. For example, in the three-dimensional space XYZ composed of the X-axis, Y-axis, and Z-axis, the first mounting frame 211 can extend approximately along the XZ-plane, and the second mounting frame 212 can extend approximately along the YZ-plane. As a result, the electrical components mounted on the first mounting frame 211 can be distributed approximately along the XZ-plane, and the electrical components mounted on the second mounting frame 212 can be distributed approximately along the YZ-plane, achieving the arrangement of electrical components in three-dimensional space. In this embodiment, by defining that the second mounting frame 212 and the first mounting frame 211 enclose to form an approximately L-shaped structure, it is conducive to ensuring both the compact arrangement of electrical components and the avoidance of interference among them.

In an embodiment, among the plurality of electrical components, there are a first connection terminal 221 and a second connection terminal 222. The first connection terminal 221 can input electrical signals or control signals, and the second connection terminal 222 can be electrically connected to the energy storage module and can also input electrical signals or control signals to the energy storage module for power distribution, detection, or management. For example, power is supplied to the energy storage module through the second connection terminal 222. The first connection terminal 221 can be a power-line input terminal, and the second connection terminal 222 can be a power-line output terminal.

At least one of the first connection terminal 221 and the second connection terminal 222 is exposed from the first side of the first mounting frame 211. For example, the first connection terminal 221 among the first connection terminal 221 and the second connection terminal 222 is exposed to the ambient air in the accommodation space 11; or the second connection terminal 222 among the first connection terminal 221 and the second connection terminal 222 is exposed to the ambient air in the accommodation space 11; or both the first connection terminal 221 and the second connection terminal 222 are exposed to the ambient air in the accommodation space 11. Thus, the external output or input can be directly connected to the structural port without the need to set up additional external ports or external plugs, simplifying the relevant structure.

It should be noted that in the prior art, due to the adoption of a closed-box structure, additional peripheral device interfaces need to be added to the box-type structure. The components of the peripheral device structure have higher prices, which increase additional costs. In this embodiment, since the open-type battery management device 20 is adopted, the interface can be further designed in an open-type manner, that is, at least one of the first connection terminal 221 and the second connection terminal 222 is exposed to the ambient air in the accommodation space 11, enabling the external output and input ports to be directly connected without the need to add peripheral device interfaces. This not only facilitates quick connection but also helps reduce the production cost of peripheral device interfaces, and results in a neater battery management device 20.

In an embodiment, the number of electrical components is multiple. The plurality of electrical components can be divided into a first device and a second device. The first device is arranged on the first side surface 2111 of the first mounting frame 211, and the second device is arranged on the second mounting frame 212. In other words, for ease of explanation, the electrical components corresponding to the first mounting frame 211 can be defined as the first device, and the electrical components corresponding to the second mounting frame 212 can be defined as the second device. In an embodiment, the first device is located on the side of the second mounting frame 212 close to the first device. For example, the first mounting frame 211 is a rectangular plate-shaped member. The long side of the first mounting frame 211 extends along the Z-axis direction, the wide side of the first mounting frame 211 extends along the X-axis direction, the wide side of the second mounting frame 212 extends along the Y-axis direction, and the long side of the second mounting frame 212 extends along the Z-axis and is located on one of the long sides of the first mounting frame 211.

The first device can be a circuit protection component, a switch component, or an isolating switch 226. The circuit protection component can include a fuse 223, and the switch component can include a relay 224. In other words, in this embodiment, the circuit protection component, the switch component, and the isolating switch 226 can be mounted on the first side surface 2111.

For example, an isolating switch mounting plate 24 and three Bakelite^{®} bases 23 are mounted on the first side surface 2111 of the first mounting frame 211. The three Bakelite^{®} bases 23 are respectively a first Bakelite^{®} base, a second Bakelite^{®} base, and a third Bakelite^{®} base. The three Bakelite^{®} bases 23 can be spaced apart along the Z-axis direction. The second Bakelite^{®} base is located between the first Bakelite^{®} base and the third Bakelite^{®} base, and the third Bakelite^{®} base is located between the second Bakelite^{®} base and the isolating switch mounting plate 24. Fuses 223 are mounted on the first Bakelite^{®} base and the second Bakelite^{®} base. Copper busbars 225 are mounted on the second Bakelite^{®} base and the third Bakelite^{®} base. Copper busbars 225 are mounted between the third Bakelite^{®} base and the isolating switch mounting plate 24. An isolating switch 226 is mounted on the isolating switch mounting plate 24.

The second device is a printed circuit board assembly 227 (PCB assembly) or a pre-charge resistor 228. Since the printed circuit board assembly 227 and the pre-charge resistor 228 have a plate-shaped structure, if they are mounted on the first mounting frame 211, they will occupy a large amount of space on the first side surface 2111 of the first mounting frame 211. Therefore, by mounting the printed circuit board assembly 227 and the pre-charge resistor 228 on the second mounting frame 212, it is conducive to making the spatial arrangement of electrical components more compact.

In this embodiment, by arranging the first device on the first mounting frame 211, arranging the second device on the second mounting frame 212, and positioning the second device on the side of the second mounting frame 212 close to the first device, the first device is approximately distributed along the first direction, and the second device is approximately distributed along the second direction, achieving distribution in different directions and improving the compactness of electrical components.

For example, the first mounting frame 211 extends along the XZ-plane, and the second mounting frame 212 extends along the YZ-plane. At this time, the printed circuit board assembly 227 and the pre-charge resistor 228 mounted on the second mounting frame 212 also extend along the YZ-plane, achieving a compact layout of multiple devices of electrical components in three-dimensional space. Specifically, the second mounting frame 212 can include a pre-charge resistor support frame 2122 and a printed circuit board support frame 2121. A pre-charge resistor 228 is mounted on the pre-charge resistor support frame 2122, and a printed circuit board assembly 227 is mounted on the printed circuit board support frame 2121. The pre-charge resistor support frame 2122 and the printed circuit board support frame 2121 can be arranged in sequence along the Z-axis direction, and the pre-charge resistor support frame 2122 and the printed circuit board support frame 2121 respectively extend along the Y-axis direction, that is, the pre-charge resistor support frame 2122 and the printed circuit board support frame 2121 respectively extend approximately along the YZ-plane.

During installation, the isolating switch 226 can be mounted on the isolating switch mounting plate 24 and then fixed on the first mounting frame 211. The relay 224 and the fuses 223 are fixed on the Bakelite^{®} base 23, and the Bakelite^{®} base 23 is directly fixed on the first mounting frame 211. The first mounting frame 211 plays the roles of supporting and fixing the devices and providing insulation. The copper busbar 225 connects the isolating switch 226, the relay 224, and the fuses 223. Due to the spatial distribution requirements, a pre-charge resistor is mounted on the pre-charge resistor support frame 2122 and then stands on the first mounting frame 211. The printed circuit board assembly 227 is also mounted on the printed circuit board support frame 2121 and then stands on the first mounting frame 211.

It should be noted that when the air conditioner is mounted on the inner wall surface of the housing 10, the cold air inside the air conditioner can pass through the energy storage module and the battery management device 20, completing a whole cooling cycle. When the cold air passes through the battery management device 20, it can take away the heat from the surfaces of large heat-generating components such as the relay 224, the fuse 223, and the copper busbar 225, playing a direct cooling role.

According to an embodiment of the present disclosure, the first mounting frame 211 and the second mounting frame 212 are respectively insulating material plates. For example, the first mounting frame 211 and the second mounting frame 212 are respectively made of polymer materials, such as epoxy resin materials, which not only have a certain strength but also have flame-retardant properties.

In some specific embodiments of the present disclosure, the thickness of the first mounting frame 211 is greater than that of the second mounting frame 212. It should be noted that the material of the closed-box structure in the prior art is sheet metal. The thickness of each position of the sheet-metal material is uniform, making it difficult to design the thickness of local positions separately according to requirements, and the weight of the box is relatively large. In this embodiment, since the first mounting frame 211 and the second mounting frame 212 are respectively made of insulating materials and are plate-shaped members, the thicknesses of the first mounting frame 211 and the second mounting frame 212 can be controlled separately. By designing the first mounting frame 211 to have a larger thickness, the supporting strength of the first mounting frame 211 can be improved. By designing the second mounting frame 212 to have a smaller thickness, the volume of the battery management device 20 occupying the accommodation space 11 can be reduced, and the overall weight of the battery management device 20 can also be reduced.

In this embodiment, by defining that the first mounting frame 211 and the second mounting frame 212 are respectively made of insulating materials, there is no need to set an insulating layer on the inner side of each electrical component mounted on the first mounting frame 211 and the second mounting frame 212, that is, insulation between the electrical components and the first mounting frame 211 and between the electrical components and the second mounting frame 212 can be achieved. Specifically, by defining the second mounting frame 212 as an insulating material member, that is, a non-metal body, there is no need to add accessories such as insulating films or insulating spacer posts on the second mounting frame 212 where the second device is mounted on the side, making the structural design more concise and saving the cost of insulating accessories. When the first mounting frame 211 is made of an insulating material, when placing the first device, there is no need to consider the electrical clearance between the copper busbar 225 and other bare high-voltage conductors as the first device and other first devices made of metal conductors. In the prior art, the reserved electrical clearance is usually around 30mm. It can be seen that the battery management device 20 of this embodiment can save more space in the layout of electrical components, and the battery management device 20 is neater.

Therefore, according to the energy storage cabinet 100 of the embodiment of the present disclosure, by adopting the open-type designed battery management device 20, the electrical components on the support frame 21 are exposed to the ambient air in the accommodating space 11. Thus, the original heat dissipation system can be omitted and the electrical components can still be cooled. Further, the original closed-box structure is replaced, thereby reducing the overall weight of the battery management device 20 and the energy storage cabinet 100.

The present disclosure also provides an energy storage system. The energy storage system includes at least one energy storage cabinet 100. The energy storage cabinet 100 is the energy storage cabinet 100 of any of the aforementioned embodiments. The energy storage cabinet 100 has the advantages of simple structures, cost savings, and weight reduction. Since the energy storage system includes the aforementioned energy storage cabinet 100, the energy storage system also has the aforementioned advantages, which will not be elaborated here.

When the energy storage system includes multiple energy storage cabinets 100, multiple energy storage cabinets 100 can be stacked. For example, two energy storage cabinets 100 are stacked in the up-down direction. The upper energy storage cabinet 100 can extend the wire harness into the lower energy storage cabinet 100 through the wire-passing hole 18, realizing the electrical connection between multiple energy storage cabinets 100.

Although some specific embodiments of the present disclosure have been described in detail through examples, those skilled in the art should understand that the aforementioned examples are only for illustration, not for limiting the scope of the present disclosure. Those skilled in the art should understand that the aforementioned embodiments can be modified without departing from the scope and spirit of the present disclosure. The scope of the present disclosure is defined by the appended claims.

## Claims

1. An energy storage cabinet (100), comprising:
a housing (10) defining an accommodation space (11);
an energy storage module being located in the accommodation space (11); and
a battery management device (20) being located in the accommodation space (11), the battery management device (20) being configured to manage the energy storage module, the battery management device (20) comprising a support frame (21) and a plurality of electrical components, the support frame (21) having an open side, and the plurality of electrical components being mounted on the open side.

2. The energy storage cabinet (100) according to claim 1, further comprising:
a temperature regulation device (30) being located in the accommodation space (11) and capable of regulating the temperature in the accommodation space (11).

3. The energy storage cabinet (100) according to claim 2, wherein the temperature regulation device (30) comprises an air conditioner.

4. The energy storage cabinet (100) according to claim 2 or 3, wherein the housing (10) comprises:
a body defining the accommodation space (11) within, and the body having a first opening (12); and
a first cover (16), the first cover (16) being movably arranged on the body, the first cover (16) being capable of opening or closing the first opening (12), and the temperature regulation device (30) being arranged on the inner side of the first cover (16).

5. The energy storage cabinet (100) according to any one of claims 1 to 4, further comprising:
a wire compartment (40) being arranged on the inner wall surface of the housing (10), a wire harness electrically connected to the electrical components being accommodated in the wire compartment (40).

6. The energy storage cabinet (100) according to claim 5, wherein the battery management device (20) is mounted on the outer side of the wire compartment (40).

7. The energy storage cabinet (100) according to any one of claims 1 to 6, wherein the housing (10) comprises two side walls adjacent to each other, the two side walls form a corner portion (17), and the battery management device (20) is arranged close to the corner portion (17).

8. The energy storage cabinet (100) according to any one of claims 1 to 7, wherein the housing (10) comprises:
a body defining the accommodation space (11) within, the body having a second opening (15); and
a second cover, the second cover is movably arranged on the body, the second cover being capable of opening or closing the second opening (15), and the second opening (15) corresponding to the position of the battery management device (20).

9. The energy storage cabinet (100) according to any one of claims 1 to 8, wherein the housing (10) is arranged with a wire-passing hole (18) along the thickness direction of the housing, and a wire harness is electrically connected to the battery management device (20) through the wire-passing hole (18).

10. The energy storage cabinet (100) according to claim 9, wherein the housing (10) comprises a top wall (13), a bottom wall, and a side wall, the side wall is located between the top wall (13) and the bottom wall and is configured to connect the top wall (13) and the bottom wall, and the wire-passing hole (18) is arranged on the top wall (13) and/or the bottom wall.

11. The energy storage cabinet (100) according to any one of claims 1 to 10, wherein the support frame (21) is made of an insulating material.

12. The energy storage cabinet (100) according to any one of claims 1 to 11, wherein the support frame (21) comprises:
a first mounting frame (211) extending along the first direction, a part of the electrical components being arranged on the first mounting frame (211); and
a second mounting frame (212) being arranged on the first mounting frame (211) and extending along the second direction, with an included angle between the first direction and the second direction, another part of the electrical components being arranged on the second mounting frame (212).

13. The energy storage cabinet (100) according to claim 12, wherein the first mounting frame (211) and the second mounting frame (212) are enclosed to form an L-shaped structure.

14. The energy storage cabinet (100) according to claim 12 or 13, wherein the first mounting frame (211) and the second mounting frame (212) are insulating material plates respectively, and the thickness of the first mounting frame (211) is greater than the thickness of the second mounting frame (212).

15. An energy storage system, comprising at least one energy storage cabinet (100), and the energy storage cabinet (100) is the energy storage cabinet (100) according to any one of claims 1 to 14.
